# EUROPÄISCHE PATENTSCHRIFT

(11) **EP 1 741 324 B1**
(45) Veröffentlichungstag und Bekanntmachung des Hinweises auf die Patenterteilung: **24.10.2007**
(21) Anmeldenummer: 05731061.7
(22) Anmeldetag: 08.04.2005
(51) Int. Cl.: H05K 7/20

(54) **MONTAGEPLATTE FÜR ELEKTRONISCHE BAUTEILE**
MOUNTING PLATE FOR ELECTRONIC COMPONENTS
PLAQUE DE MONTAGE POUR COMPOSANTS ELECTRONIQUES

(30) Priorität: 19.04.2004 DE 102004019382
(43) Veröffentlichungstag der Anmeldung: 10.01.2007
(73) Patentinhaber: Rittal GmbH & Co. KG, 35745 Herborn (DE)
(72) Erfinder: LANG, Martin, 35759 Driedorf (DE); REUTER, Wolfgang, 56479 Liebenscheid (DE); BESSERER, Horst, 35745 Herborn (DE)
(74) Vertreter: Fleck, Hermann-Joseph
(86) Internationale Anmeldenummer: PCT/EP2005/003693
(87) Internationale Veröffentlichungsnummer: WO 2005/101938

(56) Entgegenhaltungen:
- EP-A- 1 276 362
- US-A- 5 263 538
- US-A- 5 546 274
- PATENT ABSTRACTS OF JAPAN Bd. 1996, Nr. 06, 28. Juni 1996 (1996-06-28) -& JP 08 046381 A (MIYACHI TECHNOS CORP), 16. Februar 1996 (1996-02-16)

## Beschreibung

Die Erfindung betrifft eine Montageplatte für elektronische Bauteile mit in einem Plattenkörper integrierten Kühlleitungen zur Durchströmung mit einer Kühlflüssigkeit, wobei am Plattenkörper eine Befestigungseinrichtung für die Montage von zu kühlenden elektronischen Bauteilen angeordnet ist.

Es ist aus dem Stand der Technik bekannt, in einer Montageplatte bzw. -platine aus Aluminium Kühlschlangen einzusetzen, um auf der Montageplatte zu montierende elektronische Geräte, z.B. Frequenzumformer, zu kühlen. Mit einer so genannten "Coldplate" kann die Verlustwärme der elektronischen Bauteile abgeführt werden.

Die elektronischen Bauteile können auf einer derartigen bekannten Montageplatte mittels Schraubverbindungen gehalten werden. Dazu sind an den Gehäusen der elektronischen Bauteile Schraublöcher vorgesehen, durch die hindurch eine Schraube in in die Montageplatte anzubringende Gewindelöcher eingeschraubt werden können. Die bekannten Montageplatinen können jedoch wegen der Kühlschlangen nicht ohne Gefahr der Beschädigung verbohrt werden. Zudem weisen die elektronischen Bauteile oftmals unterschiedliche Abmessungen auf, so dass auch unterschiedlich Befestigungsmaße vorgegeben sind. Es ist vielfach also nicht möglich, die Montageplatte mit einem vorgefertigten Raster von Gewindelöchern zu versehen, da die an den Gehäusen der elektronischen Bauteile angebrachte Gewindelöcher mit diesen nicht fluchten.

Bei bekannten Montageplatten der Firma PADA Engineering werden die Kühlschlangen sichtbar an der Plattenoberfläche verlegt, um somit bei einer nachträglichen mechanischen Bearbeitung der Montageplatte versehentliche Beschädigungen der Kühlmittelleitungen weitgehend zu vermeiden.

Allerdings ist es bei den bekannten Montageplatten notwendig, je nach Befestigungsmaß des zu montierenden elektronischen Bauteils speziell angeordnete Gewindelöcher einzubringen. Dies ist fertigungstechnisch aufwendig.

Durch die aufgrund der Lage der Kühlschlangen vorgegebenen Montagebereiche auf der Montageplatte wird auch die Packungsdichte mehrerer zu montierender elektronsicher Bauteile reduziert, da aufgrund der Führung der Kühlmittelleitungen nicht jede Position für das Einbringen eines Gewindelochs geeignet ist.

Der relevante Stand der Technik schliesst Dokument JP-A-08 046 381 ein.

Es ist Aufgabe der Erfindung, eine Montageplatte für elektronische Bauteile anzugeben, die bei reduziertem Montageaufwand einen sicheren Halt für zu montierende elektronische Bauteile gewährleistet und die Gefahr von Beschädigungen der Kühlmittelleitungen sicher ausschließt. Zudem soll die erfindungsgemäße Montageplatte eine möglichst hohe Packungsdichte für zu montierende elektronische Bauteile ermöglichen.

Diese Aufgabe der Erfindung wird durch die Merkmale des Anspruches 1 gelöst. Vorteilhafte Weiterbildungen sind jeweils in den Unteransprüchen beschrieben.

Demgemäss weist die Befestigungseinrichtung zumindest eine im Querschnitt etwa C-förmig ausgebildete sich in Erstreckungsrichtung der Montageplatte geradlinig erstreckende erste Nut auf, in die zumindest eine Schraubenmutter zur Ausbildung einer Schraubverbindung mit einem elektronischen Bauteil verdrehsicher eingeführt werden kann. Durch diese Anordnung wird das zusätzliche Einbringen von Gewindelöchern vermieden. Die Montage ist einfach durchzuführen, wobei aufgrund der beliebigen Positionierung der Schraubenmutter in der Nut eine Anpassung an die baulichen Vorgaben der Bauteilgehäuse möglich ist.

Gemäß einem weiteren Grundgedanken weisst die Befestigungseinrichtung zumindest eine gleichartig zur ersten Nut ausgebildete und sich parallel zur ersten Nut erstreckende zweite Nut auf, deren Abstand zur ersten Nut im wesentlichen durch die senkrecht zur ersten und zweiten Nut verlaufende Erstreckungslänge des zu montierenden elektronischen Bauteils bestimmt ist. Dadurch wird sichergestellt, dass bei einem vorgegebenen Befestigungsmaß von zu montierenden elektronischen Bauteilen eine einfache Sicherung an der Montageplatte erfolgen kann.

Gemäß einer vorteilhaften Weiterbildung kann die Befestigungseinrichtung zumindest eine gleichartig zur ersten Nut und zur zweiten Nut ausgebildete und sich parallel zur zweiten Nut erstreckende weitere Nut aufweist, die sich an der von dem zu montierenden elektronischen Bauteil abgewandten Seite der zweiten Nut in einem Abstand zu dieser erstreckt, der kleiner als der Abstand zwischen der ersten Nut und der zweiten Nut ist. Mit dieser Anordnung wird einem zusätzlich verwendeten weiteren Befestigungsmaß von zu montierenden elektronischen Bauteilen Rechnung getragen.

Als erläuterndes Beispiel, daß jedoch nicht einer Aspekt der Erfindung darstellt, wird gennant, daß auf einfache Weise sich elektronische Bauteile montiere lassen, die Schraublöcher aufweisen, deren Abstand zueinander dem Abstand der zweiten Nut von der ersten Nut oder der noch weiteren Nut von der ersten Nut entspricht. Dabei können die elektronische Bauteile direkt durch Schrauben an den in die Nuten eingeführten Schraubenmuttern befestigt werden.

Gemäß der Erfindung können die zu montierenden elektronischen Bauteile deren die Befestigungsmaße nicht mit den Abständen zwischen den parallel verlaufenden Nuten übereinstimmen, d.h. die zu montierenden elektronischen Bauteile Schraublöcher aufweisen, deren Abstand zueinander kleiner als der Abstand der zweiten Nut von der ersten Nut oder kleiner als der Abstand der noch weiteren Nut von der ersten Nut ist, kann das Bauteil zumindest einseitig durch ein Winkelblech festgelegt werden, bei dem zumindest eine in das Winkelblech eingreifende Schraube an die in die entsprechende Nut eingeführte Schraubenmutter eingeschraubt wird.

Dabei kann das Winkelblech eine ebene Grundplatte zur Anlage an der Montageplatte und einen dazu abgewinkelten Klemmbereich zur klemmenden Festlegung des zu montierenden elektronischen Bauteils aufweisen. Der Klemmbereich kann dabei an einen am elektronischen Bauteil vorgesehenen Vorsprung klemmend angreifen.

Um eine besonders einfache Anpassung an unterschiedliche Befestigungsmaße von zu montierenden elektronischen Bauteilen zu erreichen, kann das Winkelblech zumindest ein sich senkrecht zur Erstreckungsrichtung der zweiten Nut oder noch weiteren Nut verlaufendes Langloch zur Aufnahme der Schraube aufweisen.

Die Schraubenmutter kann in vorteilhafter Ausbildung eine Federmutter sein.

Fertigungstechnisch ist es von Vorteil, wenn die erste Nut, die zweite Nut und/oder die noch weitere Nut mit dem Plattenkörper einstückig ausgebildet sind.

Nachfolgend wird die Erfindung anhand einer bevorzugten Ausführungsform unter Bezugnahme auf die beigefügten Zeichnungen näher erläutert.

Es zeigen:
- Figur 1: in schematischer und perspektivischer Seitenansicht eine Montageplatte ohne darauf montierte, zu kühlende elektronische Bauteile;
- Figur 2: in schematischer und perspektivischer Seitenansicht ein Winkelblech für die an unterschiedlichen Befestigungsmaße von zu montierenden elektronischen Bauteilen anpassbare Montage; und
- Figur 3: in schematischer und perspektivischer Seitenansicht die Montageplatte gemäß der Figur 1 mit darauf montierten, zu kühlende Frequenzumformern, die jeweils mit einem Winkelblech gemäß der Figur 2 einseitig klemmend gehalten sind.

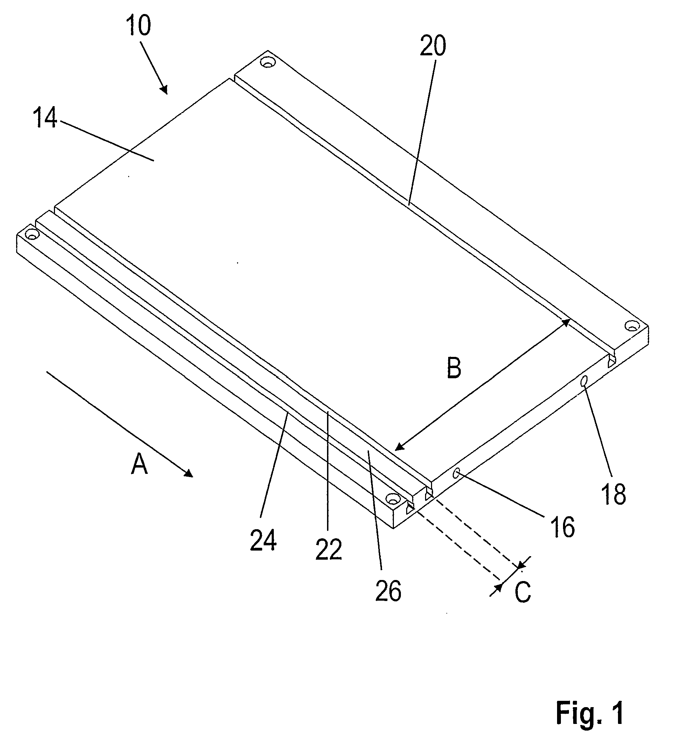

Figur 1 zeigt in schematischer und perspektivischer Seitenansicht eine Montageplatte 10 ohne darauf montierte, zu kühlende elektronische Bauteile. Die Montageplatte 10 weist einen ebenen Plattenkörper 14 aus Aluminium auf, in dem eine Kühlleitung mit Anschlüssen 16 und 18 in Form einer nicht erkennbaren Kühlschlage zur Durchströmung mit einer Kühlflüssigkeit ausgebildet ist. Der Bereich, in dem die Kühlmittelschlage integral verlegt ist, ist der Plattenkörper 14 nicht zusätzlich bearbeitet sondern flach und eben ausgebildet. An der in Figur 1 rechten Seite des Bereichs, in dem die Kühlmittelschlage integral verlegt ist, ist eine im Querschnitt etwa C-förmig ausgebildete sich in Erstreckungsrichtung (Pfeil A) der Montageplatte 10 geradlinig erstreckende erste Nut 20 einstückig mit dem Plattenkörper ausgebildet. In die erste Nut 20 lässt sich zumindest eine (nicht gezeigte) Federmutter zur Ausbildung einer Schraubverbindung mit einem elektronischen Bauteil verdrehsicher einführen. Die aufzubauenden elektronischen Bauteile können dann damit verschraubt werden.

Zur ersten Nut 20 erstreckt sich parallel eine zweite Nut 22 an der in Figur 1 linken Seite des Bereichs des Plattenkörpers, in dem die Kühlmittelschlage integral verlegt ist. Der Abstand B zwischen der ersten Nut 20 und der zweiten Nut wird zum einen durch den Bereich des Plattenkörpers, in dem die Kühlmittelschlage integral verlegt ist, und zum anderen durch die senkrecht zur ersten Nut 20 und zur zweiten Nut 22 verlaufende Erstreckungslänge eines zu montierenden elektronischen Bauteils bestimmt.

Zur ersten Nut 20 und zur zweiten Nut 22 verläuft parallel eine weitere Nut 24, die sich an der von dem zu montierenden elektronischen Bauteil abgewandten Seite 26 der zweiten Nut in einem Abstand C zu dieser erstreckt. Der Abstand C ist kleiner als der Abstand B zwischen der ersten Nut 20 und der zweiten Nut 22 und ist an ein weiteres Befestigungsmaß als in Fall der zweiten Nut 22 angepasst.

Zu montierende elektronische Bauteile die nicht Bestandteil der Erfindung sind, deren Gehäuse Schraublöcher aufweisen, deren Abstand zueinander dem Abstand B der zweiten Nut 22 von der ersten Nut 20 oder der noch weiteren Nut 24 von der ersten Nut 20 entspricht, können direkt durch Schrauben an den in die Nuten 20, 22, 24 eingeführten Schraubenmuttern befestigt werden.

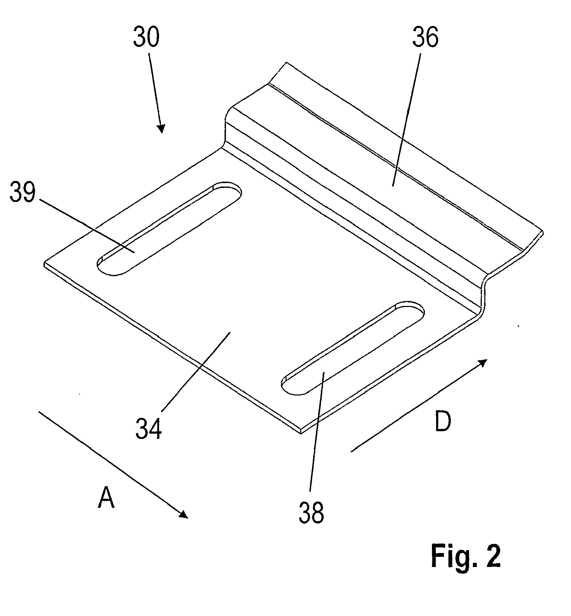

Figur 2 zeigt in schematischer und perspektivischer Seitenansicht ein Winkelblech 30 für die an unterschiedlichen Befestigungsmaße von zu montierenden elektronischen Bauteilen anpassbare Montage.

Zu montierende elektronische Bauteile, deren Gehäuse Schraublöcher aufwei-sen, deren Abstand zueinander kleiner als der (in Figur 1 gezeigte) Abstand B der zweiten Nut 22 von der ersten Nut 20 oder kleiner als der Abstand der noch weiteren Nut 24 von der ersten Nut 20 ist, können zumindest einseitig durch das Winkelblech 30 mittels zumindest einer in diese eingreifende (nicht gezeigte) Schraube an der in die entsprechende Nut 22 eingeführten Schraubenmutter klemmend festgelegt werden.

Das Winkelblech 30 weist eine ebene Grundplatte 34 zur Anlage an der Montageplatte 10 und einen dazu abgewinkelten, einstückig ausgebildeten Klemmbereich 36 zur klemmenden Festlegung des zu montierenden elektronischen Bauteils auf.

Das Winkelblech 30 weist zwei sich senkrecht (Pfeil D) zur Erstreckungsrichtung (Pfeil A) der zweiten Nut 22 oder noch weiteren Nut 24 verlaufende Langlöcher 38 und 39 zur Aufnahme einer (nicht gezeigten) Schraube auf.

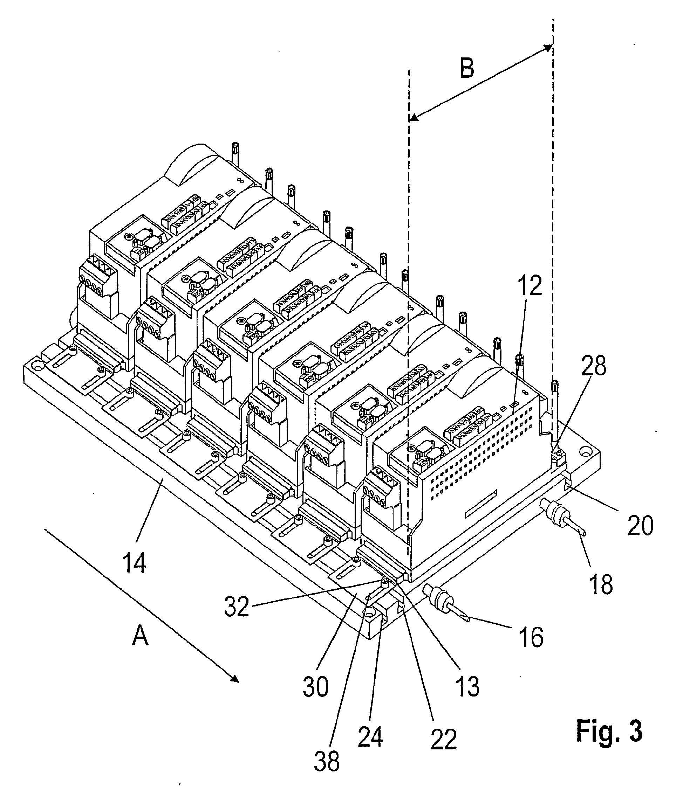

Figur 3 zeigt in schematischer und perspektivischer Seitenansicht die Montageplatte 10 gemäß der Figur 1 mit darauf montierten, zu kühlende Frequenzumformern 12, die jeweils mit einem Winkelblech 30 gemäß der Figur 2 einseitig klemmend gehalten sind.

Die Frequenzumformer, deren Erstreckung B nicht mit den Abständen zwischen den beiden Nuten 20 und 22 übereinstimmt, sind an der in Figur 3 rechten Seite jeweils mit Schrauben, die in in die Nut 20 eingeführte (nicht gezeigte) Federmuttern eingreifen, verschraubt. In Figur 3 ist eine derartige Schraube mit dem Bezugszeichen 28 versehen.

An der in Figur 3 linken Seite sind die Frequenzumsetzer 12 jeweils mit einem zusätzlichen Winkelblech, von denen eines mit dem Bezugszeichen 30 dargestellt ist, verklemmt. Beispielsweise in des Langloch 38 des dargestellten Winkelblechs 30 greift eine Schraube 32 in eine in die zweite Nut 22 eingeführte (nicht gezeigte) Federmutter ein. Das Winkelblech 30 greift an einem Vorsprung 13 am Gehäuse des Frequenzumsetzer 12 klemmend an. Durch die Langlochbefestigung wird das zu den Nutabständen nicht passende Befestigungsmaß ausgeglichen.

## Patentansprüche

1. Montageplatte (10) für elektronische Bauteile (12) mit in einem Plattenkörper (14) integrierten Kühlleitungen (16, 18) zur Durchströmung mit einer Kühlflüssigkeit, wobei am Plattenkörper (14) eine Befestigungseinrichtung für die Montage von zu kühlenden elektronischen Bauteilen angeordnet ist,
wobei die Befestigungseinrichtung zumindest eine im Querschnitt etwa C-förmig ausgebildete sich in Erstreckungsrichtung (A) der Montageplatte (10) geradlinig erstreckende erste Nut (20) aufweist, in die zumindest eine Schraubenmutter zur Ausbildung einer Schraubverbindung mit einem elektronischen Bauteil (12) verdrehsicher einführbar ist, und
wobei die Befestigungseinrichtung zumindest eine gleichartig zur ersten Nut (20) ausgebildete und sich parallel zur ersten Nut (20) erstreckende zweite Nut (22) aufweist, deren Abstand (B) zur ersten Nut (20) im Wesentlichen durch die senkrecht zur ersten und zweiten Nut (20, 22) verlaufende Erstreckungslänge (B) des zu montierenden elektronischen Bauteils (12) bestimmt ist,
**dadurch gekennzeichnet, dass**
die zu montierenden elektronischen Bauteile (12) Schraublöcher aufweisen, deren Abstand zueinander kleiner als der Abstand (B) der zweiten Nut (22) von der ersten Nut (20) ist, und die zu montierenden elektronischen Bauteile (12) zumindest einseitig durch ein Winkelblech (30) mittels Schrauben (32) an Schraubenmuttern klemmend festlegbar sind, die in die entsprechende Nut (22) eingeführt sind.

2. Montageplatte nach Anspruch 1,
**dadurch gekennzeichnet, dass**
die Befestigungseinrichtung zumindest noch eine gleichartig zur ersten Nut (20) und zur zweiten Nut (22) ausgebildete und sich parallel zur zweiten Nut (22) erstreckende weitere Nut (24) aufweist, die sich an der von dem zu montierenden elektronischen Bauteil abgewandten Seite (26) der zweiten Nut in einem Abstand (C) zu dieser erstreckt, der kleiner als der Abstand (B) zwischen der ersten Nut (20) und der zweiten Nut (22) ist.

3. Montageplatte nach Anspruch 2,
**dadurch gekennzeichnet, dass**
die zu montierenden elektronischen Bauteile (12) Schraublöcher aufweisen, deren Abstand zueinander kleiner als der Abstand der noch weiteren Nut (24) von der ersten Nut (20) ist, und die zu montierenden elektronischen Bauteile (12) zumindest einseitig durch ein Winkelblech (30) mittels zumindest einer in diese eingreifende Schraube (32) an die in die entsprechende Nut (22) eingeführten Schraubenmutter klemmend festlegbar sind.

4. Montageplatte nach einem der Ansprüche 1 bis 3,
**dadurch gekennzeichnet, dass**
das Winkelblech (30) eine ebene Grundplatte (34) zur Anlage an der Montageplatte (10) und einen dazu abgewinkelten Klemmbereich (36) zur klemmenden Festlegung des zu montierenden elektronischen Bauteils (12) aufweist.

5. Montageplatte nach Anspruch 4,
**dadurch gekennzeichnet, dass**
das Winkelblech (30) zumindest ein sich senkrecht (D) zur Erstreckungsrichtung (A) der zweiten Nut (22) oder noch weiteren Nut (24) verlaufendes Langloch (38) zur Aufnahme der Schraube (32) aufweist.

6. Montageplatte nach einem der Ansprüche 1 bis 5,
**dadurch gekennzeichnet, dass**
die Schraubenmutter eine Federmutter ist.

7. Montageplatte nach einem der Ansprüche 1 bis 6,
**dadurch gekennzeichnet, dass**
die erste Nut (20), die zweite Nut (22) und/oder die noch weitere Nut (24) mit dem Plattenkörper einstückig ausgebildet sind.

## Claims

1. Mounting plate (10) for electronic components (12), comprising cooling lines (16, 18), which are integrated in a plate body (14), for a cooling liquid to flow through, with a fastening device for mounting electronic components to be cooled being arranged on the plate body (14), with the fastening device having at least one first groove (20) which has an approximately C-shaped cross section, extends in a rectilinear manner in the extension direction (A) of the mounting plate (10) and into which at least one screw nut for forming a screw connection with an electronic component (12) can be inserted in a rotationally secure manner, and with the fastening device having at least one second groove (22) which is formed in an identical manner to the first groove (20), extends parallel to the first groove (20) and whose distance (B) from the first groove (20) is determined substantially by the extension length (B), which runs perpendicular to the first and second grooves (20, 22), of the electronic component (12) to be mounted, **characterized in that** the electronic components (12) to be mounted have screw holes whose distance from one another is less than the distance (B) of the second groove (22) from the first groove (20), and the electronic components (12) to be mounted can be secured in a clamped manner to screw nuts which are inserted into the corresponding groove (22) at least on one side by an angular metal sheet (30) by means of screws (32).

2. Mounting plate according to Claim 1, **characterized in that** the fastening device has at least one further groove (24) which is formed in an identical manner to the first groove (20) and to the second groove (22), extends parallel to the second groove (22), and which, on that side (26) of the second groove which faces away from the electronic component to be mounted, extends at a distance (C) from the said groove which is less than the distance (B) between the first groove (20) and the second groove (22).

3. Mounting plate according to Claim 2, **characterized in that** the electronic components (12) to be mounted have screw holes whose distance from one another is less than the distance of the further groove (24) from the first groove (20), and the electronic components (12) to be mounted can be secured in a clamped manner to the screw nut inserted into the corresponding groove (22) at least on one side by an angular metal sheet (30) by means of at least one screw (32) which engages in the said angular metal sheet.

4. Mounting plate according to one of Claims 1 to 3, **characterized in that** the angular metal sheet (30) has a flat base plate (34) for bearing against the mounting plate (10) and a clamping region (36), which is at an angle to the said base plate, for securing the electronic component (12) to be mounted in a clamped manner.

5. Mounting plate according to Claim 4, **characterized in that** the angular metal sheet (30) has at least one slot (38), which runs perpendicular (D) to the extension direction (A) of the second groove (22) or further groove (24), for receiving the screw (32).

6. Mounting plate according to one of Claims 1 to 5, **characterized in that** the screw nut is a spring nut.

7. Mounting plate according to one of Claims 1 to 6, **characterized in that** the first groove (20), the second groove (22) and/or the further groove (24) are integrally formed with the plate body.

## Revendications

1. Plaque de montage (10) pour composants électroniques (12), qui présente :
des conduits de refroidissement (16, 18) intégrés dans un corps de plaque (14) et destinés à être traversés par un liquide de refroidissement,
un dispositif de fixation qui permet le montage des composants électroniques à refroidir étant disposé sur le corps de plaque (14) et le dispositif de fixation présentant au moins une première rainure (20) à section transversale sensiblement en forme de C qui s'étend en ligne droite dans la direction d'extension (A) de la plaque de montage (10) et dans laquelle au moins un écrou fileté permettant de réaliser une liaison filetée avec un composant électronique (12) peut être inséré en étant empêché de tourner,
le dispositif de fixation présentant au moins une deuxième rainure (22) configurée de manière identique à la première rainure (20) et s'étendant parallèlement à la première rainure (20), dont la distance (B) par rapport à la première rainure (20) dans la direction perpendiculaire à la première et à la deuxième rainure (20, 22) est définie essentiellement par la longueur de l'extension (B) du composant électronique (12) à monter,
**caractérisée en ce que**
les composants électroniques (12) à monter présentent des trous filetés dont l'écartement mutuel est plus petit que la distance (B) entre la deuxième rainure (22) et la première rainure (20), les composants électroniques (12) à monter pouvant être immobilisés de manière serrée au moins d'un côté par une tôle coudée (30), au moyen de vis (32) placées sur les écrous filetés et insérées dans la rainure (22) correspondante.

2. Plaque de montage selon la revendication 1, **caractérisée en ce que** le dispositif de fixation présente encore une autre rainure (24) similaire à la première rainure (20) et à la deuxième rainure (22) et qui s'étend parallèlement à la deuxième rainure (22) sur le côté (28) de la deuxième rainure non tourné vers le composant électronique à monter à une distance (C) de la deuxième rainure plus petite que la distance (B) entre la première rainure (20) et la deuxième rainure (22).

3. Plaque de montage selon la revendication 2, **caractérisée en ce que** les composants électroniques (12) à monter présentent des trous filetés dont l'écart mutuel est plus petit que la distance entre la rainure supplémentaire (24) et la première rainure (20), les composants électroniques (12) à monter pouvant être immobilisés par serrage au moins d'un côté par une tôle coudée (30) au moyen d'au moins une vis (32) qui s'engage dans l'écrou fileté inséré dans la rainure (22) correspondante.

4. Plaque de montage selon l'une des revendications 1 à 3, **caractérisée en ce que** la tôle coudée (30) présente une plaque de base plane (34) destinée à être placée sur la plaque de montage (10) et une zone de serrage (36) coudée par rapport à la plaque de base et destinée à immobiliser par serrage le composant électronique (12) à monter.

5. Plaque de montage selon la revendication 4, **caractérisée en ce que** pour la réception de la vis (32), la tôle coudée (30) présente au moins un trou oblong (38) qui s'étend perpendiculairement (D) à la direction d'extension (A) de la deuxième rainure (22) ou de l'autre rainure (24).

6. Plaque de montage selon l'une des revendications 1 à 5, **caractérisée en ce que** l'écrou fileté est un écrou à ressort.

7. Plaque de montage selon l'une des revendications 1 à 6, **caractérisée en ce que** la première rainure (20), la deuxième rainure (22) et/ou l'autre rainure (24) sont formées d'un seul tenant avec le corps de la plaque.
